(19) **Europäisches Patentamt**

**European Patent Office**

**Office européen des brevets**

(11) **EP 1 715 501 A1**

(12) **EUROPÄISCHE PATENTANMELDUNG**

(43) Veröffentlichungstag:
**25.10.2006 Patentblatt 2006/43**

(51) Int Cl.:
*H01H 85/10* $^{(2006.01)}$

(21) Anmeldenummer: **05008912.7**

(22) Anmeldetag: **22.04.2005**

(84) Benannte Vertragsstaaten:
**AT BE BG CH CY CZ DE DK EE ES FI FR GB GR HU IE IS IT LI LT LU MC NL PL PT RO SE SI SK TR**
Benannte Erstreckungsstaaten:
**AL BA HR LV MK YU**

(71) Anmelder: **DBK David + Baader GmbH**
**76870 Kandel/Pfalz (DE)**

(72) Erfinder:
• **Gschwind, Thomas**
**67098 Bad Dürkheim (DE)**

• **Bauer, Hans-Peter**
**76889 Klingenmünster (DE)**

(74) Vertreter: **Grünecker, Kinkeldey,**
**Stockmair & Schwanhäusser**
**Anwaltssozietät**
**Maximilianstrasse 58**
**80538 München (DE)**

(54) **Schmelzsicherung für Leiterplattenmontage**

(57) Eine Schmelzsicherung für Leiterplattenmontage besitzt Anschlüsse, die mit Leiterbahnen auf der Leiterplatte elektrisch verbindbar sind, sowie mindestens eine leitfähige und schmelzbare Verbindung zwischen den Anschlüssen. Sie ist so gestaltet, dass sie kostengünstig einstückig aus Blech oder leitfähigem Kunststoff gefertigt werden kann.

Fig.5

**Beschreibung**

Die vorliegende Erfindung bezieht sich auf eine Schmelzsicherung zum Einbau in die Leiterplatte einer gedruckten Schaltung.

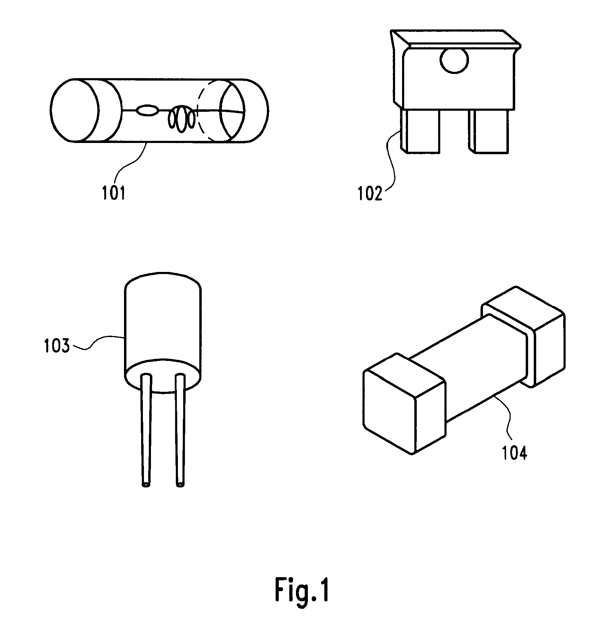

Fig. 1 zeigt einige herkömmliche Bauformen von Schmelzsicherungen. Dem Fachmann allgemein bekannt sind Schmelzsicherungen in Form von Feinsicherungen 101, bei denen das Schmelzelement in einem zylinderförmigen Glasgehäuse montiert ist, dessen Enden mit Kontaktflächen aus Metall versehen sind. Des Weiteren sind mit Messerkontakten versehene steckbare Schmelzsicherungen 102 bekannt, wie sie im Allgemeinen in Kraftfahrzeugen Verwendung finden. Bei dieser Bauform wird das Schmelzelement in einem Kunststoffgehäuse gehalten. Sollen solche Sicherungen in einer gedruckten Schaltung Verwendung finden, wird im Allgemeinen zusätzlich eine Fassung oder Halterung benötigt, die an der Leiterplatte befestigt und mit den darauf befindlichen Leiterbahnen verlötet wird.

Des Weiteren sind Schmelzsicherungen 103 zur direkten Leiterplattenmontage bekannt, bei denen sich das Schmelzelement in einem Kunststoffgehäuse befindet, und die mittels radialer Anschlussdrähte in eine gedruckte Schaltung eingelötet werden können. Weiterhin sind Schmelzsicherungen in Chipbauform 104 bekannt, die für Oberflächenmontage auf Leiterplatten geeignet sind.

Die erwähnten Schmelzsicherungen bestehen aus mehreren Elementen, und ihre Herstellung ist daher entsprechend aufwändig und kostenintensiv.

Es ist daher eine Aufgabe der vorliegenden Erfindung, eine Schmelzsicherung zur Montage in einer Leiterplatte bereit zu stellen, die aufgrund ihrer einfachen Konstruktion besonders kostengünstig herstellbar ist.

Diese Aufgabe wird durch eine Schmelzsicherung mit dem Kennzeichen des Patentanspruchs 1 gelöst.

Eine besonders kostengünstige Fertigung wird erfindungsgemäß dadurch ermöglicht, dass die Schmelzsicherung einstückig gefertigt wird. Durch den Wegfall von zusätzlichen Gehäuseteilen werden Montageschritte überflüssig und die damit verbundenen Kosten eingespart. Durch diese vereinfachte Herstellung wird in vorteilhafter Weise auch die Fertigungsausbeute erhöht und das Risiko für Qualitätseinbußen durch Fertigungsfehler vermindert.

In einer vorteilhaften Ausführungsform besteht die Schmelzsicherung aus einem Material, dessen Schmelzpunkt höher liegt als die in Lötprozessen auftretenden Temperaturen, ab ca. 220°C, und niedriger liegt als der Schmelzpunkt von Kupfer, ca. 1085°C. Dadurch ist sichergestellt, dass die Schmelzsicherung in eine gedruckte Schaltung eingelötet werden kann ohne selbst zu schmelzen, und dass sie den Stromfluss unterbricht, bevor Leiterbahnen der gedruckten Schaltung thermisch beschädigt werden.

In einer Ausführungsform wird die erfindungsgemäße Schmelzsicherung aus Blech gefertigt. Dies ermöglicht eine besonders kostengünstige Herstellung, beispielsweise durch Stanzen, Laserschneiden, Wasserstrahlschneiden oder Ätzen.

In einer besonders vorteilhaften Ausgestaltungsform besteht die erfindungsgemäße Schmelzsicherung aus Zink.

In einer alternativen Ausführungsform ist die erfindungsgemäße Schmelzsicherung aus leitfähigem Kunststoff gefertigt. Dies ermöglicht eine kostengünstige Herstellung, zum Beispiel im Spritzgussverfahren.

In einer vorteilhaften Ausführungsform der erfindungsgemäßen Schmelzsicherung ist mindestens ein Anschluss in Durchbrüche einer Leiterplatte einsetzbar. Dies ermöglicht eine kostengünstige und zuverlässige Montage, da die Schmelzsicherung nach dem Einstecken in die Durchbrüche der Leiterplatte ohne weitere Befestigungsmaßnahme bereits fixiert ist, bevor beispielsweise eine Lötverbindung hergestellt wird. Auch bei einem Erweichen der Lötstelle bei einer Erwärmung der Schmelzsicherung unter Last ergibt sich dadurch eine zusätzliche Fixierung und damit erhöhte Zuverlässigkeit.

In einer weiteren vorteilhaften Ausgestaltungsform besitzt die Schmelzsicherung an mindestens einem der Anschlüsse, die in Durchbrüche einer Leiterplatte eingesetzt werden, mindestens einen Vorsprung im Wesentlichen quer zur Einführungsrichtung des Anschlusses in dem Durchbruch der Leiterplatte. Dieser Vorsprung bewirkt zusammen mit einem geeignet dimensionierten Durchbruch in der Leiterplatte ein Fixieren der Schmelzsicherung in bestücktem Zustand.

In einer besonders vorteilhaften Ausführungsform verfügt die Schmelzsicherung über eine Auflagefläche, die sie im eingesetzten Zustand auf der Oberfläche einer Leiterplatte abstützt, und zumindest ein Vorsprung besitzt in Einführungsrichtung des Anschlusses einen Abstand von der Auflagefläche, der im Wesentlichen einer vorgegebenen Dicke einer Leiterplatte entspricht. Dies bewirkt in vorteilhafter Weise ein Einrasten der Schmelzsicherung in der Leiterplatte im eingesetzten Zustand.

In einer alternativen Ausführungsform ist mindestens ein Anschluss der erfindungsgemäßen Schmelzsicherung für eine flächige Verbindung mit Leiterbahnen auf der Leiterplatte ausgebildet. Dies ermöglicht die Verwendung auf Leiterplatten, die ausschließlich mit oberflächenmontierbaren Bauelementen bestückt werden, wodurch die Montagekosten reduziert werden.

In einer weiteren vorteilhaften Ausführungsform weist mindestens einer der für eine flächige Verbindung ausgebildeten Anschlüsse einen Durchbruch oder eine Einbuchtung für eine Schraubverbindung oder Nietverbindung auf.

Dadurch kann die Schmelzsicherung zusätzlich auf der Leiterplatte fixiert werden, um ein Abfallen zu verhindern, wenn sich die Lötstellen aufgrund der Belastung der Schmelzsicherung erwärmen.

In einer weiteren vorteilhaften Ausführungsform der Erfindung besteht die leitfähige und schmelzbare Verbindung zwischen den Anschlüssen aus mindestens zwei parallel geschalteten Stegen. Dadurch wird in vorteilhafter Weise die Größe der beim Durchschmelzen der schmelzbaren Verbindung entstehenden Schmelztropfen verringert. Dadurch wird eine Gefährdung anderer Teile der gedruckten Schaltung durch die Schmelztropfen vermieden.

In einer besonders vorteilhaften Ausführungsform der vorliegenden Erfindung besteht die leitfähige und schmelzbare Verbindung aus mindestens zwei parallel geschalteten Stegen mit unterschiedlicher minimaler Querschnittsfläche. Im Überlastfall wird bei einer solchen Schmelzsicherung zuerst der Steg unterbrechen, der die größte Stromdichte aufweist. Dadurch erhöht sich die Stromdichte in den übrigen Stegen, so dass diese ebenfalls unterbrechen.

In einer weiteren vorteilhaften Ausführungsform der vorliegenden Verbindung besitzt eine Schmelzsicherung mindestens drei Anschlüsse und mindestens zwei leitfähige und schmelzbare Verbindungen, bei denen mindestens zwei der leitfähigen und schmelzbaren Verbindungen in Reihe geschaltet sind und die Anschlüsse jeweils an Enden der Reihenschaltung sowie an Knotenpunkten zwischen den leitfähigen und schmelzbaren Verbindungen angeschlossen sind. Dies ermöglicht es in besonders vorteilhafter und kostengünstiger Weise, mit einer Schmelzsicherung mehrere Stromkreise abzusichem.

In einer weiteren vorteilhaften Ausführungsform der vorliegenden Erfindung besitzt eine Schmelzsicherung mindestens zwei Anschlüsse und mindestens zwei leitfähige und schmelzbare Verbindungen, wobei jeder Anschluss über jeweils eine leitfähige und schmelzbare Verbindung mit einem gemeinsamen elektrischen Knotenpunkt verbunden ist. Auch bei dieser Ausführungsform lassen sich mit Hilfe einer einzigen Schmelzsicherung mehrere Stromkreise absichern.

In einer weiteren vorteilhaften Ausführungsform wird die Schmelzsicherung in einem Anlieferungszustand durch eine brechbare schneidbare oder stanzbare Verbindung an einem Gurt gehalten, wobei die Schmelzsicherung und der Gurt aus einem Stück gefertigt sind. Dies gewährleistet eine kostengünstige Massenfertigung, einen einfachen und sicheren Transport der Schmelzsicherung sowie eine vereinfachte Handhabung bei der Montage derselben.

Eine weitere Ausführungsform der vorliegenden Erfindung betrifft eine Leiterplatte, die mit mindestens einer erfindungsgemäßen Schmelzsicherung bestückt ist. Eine solche Leiterplatte ermöglicht eine besonders kostengünstige Absicherung eines oder mehrerer Stromkreise der darauf befindlichen gedruckten Schaltung.

In einer besonders vorteilhaften Ausführungsform sind die Anschlüsse der Schmelzsicherung mit Leiterbahnen elektrisch und wärmeleitfähig verbunden, zumindest eine der Leiterbahnen besitzt eine Kontaktfläche zur Wärmeableitung, und diese Kontaktfläche zur Wärmeableitung ist mit einem der Anschlüsse der Schmelzsicherung durch eine Leiterbahn verbunden, die breiter ist als die Länge dieser Leiterbahn zwischen der Kontaktfläche zur Wärmeableitung und demjenigen mit der Leiterbahn verbundenen Anschluss der Schmelzsicherung, der am nächsten zu der Kontaktfläche zur Wärmeableitung gelegen ist. Dadurch wird die Temperatur der Schmelzsicherung möglichst nahe an der Umgebungstemperatur gehalten. Dadurch wird ermöglicht, dass die Schmelzsicherung in einer höheren Umgebungstemperatur bei einem geringeren Strom unterbricht als in einer niedrigeren Umgebungstemperatur.

Eine weitere Ausgestaltungsform der Erfindung betrifft eine elektrische Heizvorrichtung, die mit mindestens einer der vorbeschriebenen Leiterplatten versehen ist. Dadurch lassen sich Elemente der elektrischen Schaltung der Heizvorrichtung auf kostengünstige Weise gegen Überlast schützen.

In einer besonders vorteilhaften Ausführungsform besitzt eine Heizvorrichtung weiterhin mindestens einen Halbleiterschalter zum Schalten eines Heizstromes, wobei das Gehäuse des Halbleiterschalters mit der Schmelzsicherung thermisch derart verbunden ist, dass für beide eine im Wesentlichen gleiche Umgebungstemperatur herrscht. Dadurch ist es möglich, den Strom, bei dem die Schmelzsicherung den Stromkreis unterbricht, an die temperaturabhängige Strombelastbarkeit des Halbleiterschalters anzupassen.

Anhand der in den angehängten Zeichnungen dargestellten Ausgestaltungen wird die Erfindung im Folgenden näher erläutert. Ähnliche oder korrespondierende Einzelheiten sind in den Figuren mit denselben Bezugszeichen versehen. Es zeigen:

Fig. 1    Bauformen von Schmelzsicherungen nach dem Stand der Technik;

Fig. 2    verschiedene Ausführungsformen der erfindungsgemäßen Schmelzsicherung;

Fig. 3    verschiedene Ausführungsformen der erfindungsgemäßen Schmelzsicherung, bei denen sich die elektrisch leitfähige und schmelzbare Verbindung nach der Montage auf der Leiterplatte in einem Durchbruch der Leiterplatte befindet;

Fig. 4    verschiedene Ausführungsformen der erfindungsgemäßen Schmelzsicherung, bei denen die Anschlüsse durch Vorsprünge in den Durchbrüchen der Leiterplatte fixiert werden;

Fig. 5 eine mögliche tatsächliche Ausführungsform der vorliegenden Erfindung;

Fig. 6 ein Beispiel für eine gegurtete Auslieferungsform der erfindungsgemäßen Schmelzsicherung;

Fig. 7 die Abhängigkeit des maximalen Stromes einer erfindungsgemäßen Schmelzsicherung von der Umgebungstemperatur;

Fig. 8 das Leiterbahnbild einer Leiterplatte zur Montage der erfindungsgemäßen Schmelzsicherung; und

Fig. 9 eine elektrische Heizvorrichtung, in der eine Leiterplatte wie in Fig. 7 gezeigt montiert ist.

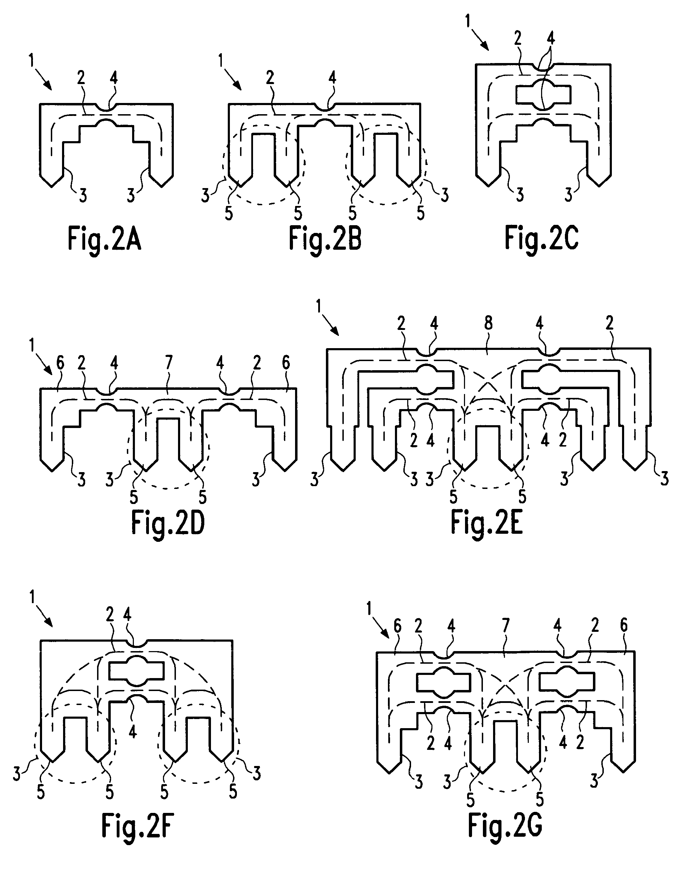

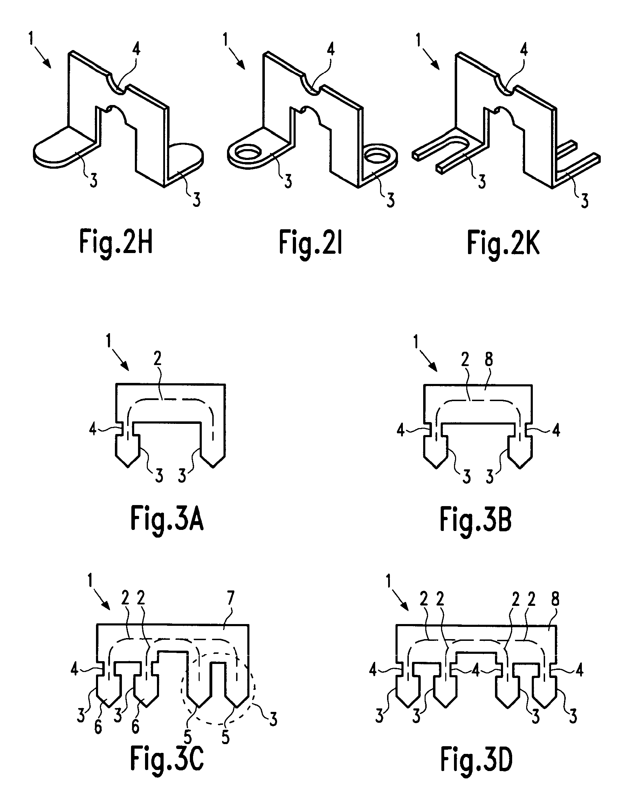

Anhand von Fig. 2 sollen im Folgenden die wesentlichen Elemente einer Schmelzsicherung nach der vorliegenden Erfindung erläutert werden. Dabei kommt es für die Grundidee der vorliegenden Erfindung weniger auf die in den Figuren beispielhaft gezeigte Ausformung der Schmelzsicherung an, sondern auf die zugrundeliegenden prinzipiellen Merkmale.

In Fig. 2A ist eine Schmelzsicherung 1 gezeigt mit zwei Anschlüssen 3 die über eine leitfähige und schmelzbare Verbindung 2 verbunden sind. Durch diese leitfähige und schmelzbare Verbindung 2 kann im Funktionsfall Strom von einem ersten Anschluss 3 zum zweiten Anschluss fließen. Eine Stelle 4, an der die Stromdichte aufgrund einer Querschnittsverengung ein örtliches Maximum erreicht, soll im Folgenden Steg genannt werden. Übersteigt der Stromfluss entlang der leitfähigen Schmelzverbindung 2 einen bestimmten durch das Material, die Form und die in der Einbausituation vorgegebene Wärmeableitung definierten Wert, so wird die Temperatur der Schmelzsicherung, im Allgemeinen zuerst am Steg 4, den Schmelzpunkt des Materials, aus dem sie besteht, überschreiten. Dadurch wird der Steg abschmelzen und die leitfähige und schmelzbare Verbindung 2 und damit den Stromfluss unterbrechen.

Die Anschlüsse 3 sind so ausgeführt, dass sie in Durchbrüche einer Leiterplatte eingesetzt werden und mit Leiterbahnen elektrisch verbunden werden können. Eine solche Verbindung kann durch Löten, Schweißen oder Nieten hergestellt werden.

Für eine vereinfachte und kostengünstige Herstellung ist die Schmelzsicherung 1 so ausgeformt, dass sie in einem Stück hergestellt werden kann. Im einfachsten Fall besitzt sie eine ebene Oberfläche und eine konstante Dicke, so dass sie aus Blech in einem Arbeitsgang durch Stanzen, Laserschneiden, Wasserstrahlschneiden oder Ätzen aus einem größeren Blechstück gefertigt werden kann. Es ist aber auch ohne größere zusätzliche Kosten möglich, der Schmelzsicherung durch Biegen eine andere Form zu geben oder an einzelnen Stellen die Dicke durch Pressen gezielt zu verringern. Wie dem Fachmann allgemein bekannt, können solche Arbeitsgänge zusammen mit dem der Vereinzelung dienenden Arbeitsgang in einem Schritt ausgeführt werden. Zum Beispiel könnte in einem Werkzeug und durch einen Arbeitsgang das Teil ausgestanzt, in eine andere Form gebogen und beispielsweise am Steg 4 dünner gepresst werden.

Eine andere Ausführungsform der Schmelzsicherung 1 ist so ausgebildet, dass sie beispielsweise durch Druckguss oder Spritzguss aus Metall oder aus leitfähigem Kunststoff hergestellt werden kann. Diese Ausführungsform ermöglicht weitere Varianten der Ausgestaltung, beispielsweise mit Schnappverbindungen zur Befestigung in einer Leiterplatte oder einer anderen Leiterstruktur.

Die Anschlüsse 3 können je nach Erfordernis und Anwendungsfall unterschiedlich ausgebildet sein. So kann es sich beispielsweise um Stifte mit annähernd quadratischem Querschnitt, um messerartige Anschlüsse oder um langgestreckte Laschen handeln. In Fig. 2B ist eine Ausführungsform gezeigt, in der jeder Anschluss aus zwei Stiften besteht. Genauso können einzelne oder mehrere Anschlüsse 3 aus einer Vielzahl von Stiften, Messerkontakten oder Laschen bestehen.

Im einfachsten Fall besteht die leitfähige und schmelzbare Verbindung 2 aus einem einzigen Strompfad, der über einen einzigen Steg 4 vom ersten Anschluss zum zweiten führt. Genauso kann die leitfähige und schmelzbare Verbindung 2 aber auch über zwei oder mehr einzeln unterbrechbare Strompfade verfügen, die jeweils über mindestens einen Steg 4 führen (siehe Fig. 2C). Im Überlastfall wird dabei zunächst einer der Stege 4 abschmelzen und den darüberführenden Strompfad unterbrechen. Dadurch erhöht sich die Stromdichte in dem oder den übrigen Steg(en), so dass auch diese abschmelzen und die gesamte schmelzbare Verbindung 2 unterbrochen wird, die dadurch den Stromfluss unterbricht. Das geschmolzene Material erstarrt in der Regel nach der Unterbrechung des Stromflusses zu einem Schmelztropfen. Dabei besitzen mehrere parallel geschaltete Stege den Vorteil, dass sich kleinere Schmelztropfen bilden und dadurch die gedruckte Schaltung weniger gefährden, als dies bei einem größeren Schmelztropfen der Fall sein kann. Ein Schmelztropfen könnte sich beispielsweise von den Resten der Schmelzsicherung lösen und an anderer Stelle der gedruckten Schaltung einen Kurzschluss verursachen.

In einer einzigen Schmelzsicherung 1 lassen sich in geeigneter Weise auch zwei oder mehrere in Reihe geschaltete leitfähige und schmelzbare Verbindung verwirklichen, wie in Fig. 2D gezeigt. Dabei befinden sich sowohl an den Endpunkten 6 der Reihenschaltung als auch an einem Knotenpunkt 7 zwischen den leitfähigen und schmelzbaren Verbindungen 2 jeweils Anschlüsse 3. Dadurch lassen sich zwei oder mehr Stromkreise unabhängig voneinander absichern. Eine Variante, bei der eine Vielzahl von Stromkreisen unabhängig voneinander durch eine Schmelzsicherung 1 abgesichert werden können, ist in Fig. 2E gezeigt. An einem Knotenpunkt 8 befindet sich ein Anschluss 3, der in diesem Fall aus zwei Stiften 5 besteht. Von diesem Knotenpunkt aus führen leitfähige und schmelzbare Verbindungen 2 über Stege 4 zu weiteren Anschlüssen 3. In dem gezeigten Beispiel können so vier Stromkreise unabhängig voneinander abgesichert werden.

Weiterhin sind auch Kombinationen der oben beschriebenen Varianten möglich. Fig. 2F zeigt beispielsweise eine Schmelzsicherung 1 mit zwei parallel geschalteten Stegen 4, deren Anschlüsse 3 jeweils aus zwei Stiften 5 bestehen. In Fig. 2G ist eine Schmelzsicherung 1 gezeigt mit zwei in Reihe geschalteten leitfähigen und schmelzbaren Verbindungen 2, die jeweils parallel geschaltete Stege umfassen. Dabei ist der am Knotenpunkt 7 angeschlossene Anschluss 3 mit zwei Stiften 5 versehen. In ähnlicher Weise ist eine praktisch unbegrenzte Anzahl von Kombinationen möglich.

Die erfindungsgemäße Schmelzsicherung kann auch für eine Oberflächenmontage auf Leiterplatten oder anderen Leiterstrukturen ausgebildet werden. Zwei beispielhafte Ausführungsformen sind in Fig. 2H, Fig. 2I und Fig. 2K gezeigt. Die Anschlüsse 3 der Schmelzsicherung in Fig. 2H ermöglichen eine Lötverbindung mit Kontaktflächen auf der Leiterplatte. Sind die Anschlüsse mit Durchbrüchen wie in Fig. 2I oder Einbuchtungen wie in Fig. 2K versehen, so wird dadurch eine Verbindung durch Schrauben oder Nieten ermöglicht. Selbstverständlich sind weitere Ausführungsformen der Anschlüsse möglich, ohne vom Prinzip der Erfindung abzuweichen. Ebenso können die verschiedenen Ausführungsformen der Anschlüsse 3 untereinander und mit den verschiedenen in Fig. 2AG gezeigten Konfigurationen von Anschlüssen 3, schmelzbaren Verbindungen 2 und Stegen 4 kombiniert werden.

Wie schon erwähnt, kann ein abfallender Schmelztropfen die gedruckte Schaltung an anderer Stelle durch einen Kurzschluss gefährden. Diese Gefahr kann auch dadurch verringert werden, dass wie in Fig. 3 gezeigt, die Stege an einer Stelle der Schmelzsicherung ausgebildet werden, die sich nach dem Einsetzen der Schmelzsicherung in eine Leiterplatte innerhalb eines Durchbruchs in der Leiterplatte befindet. Dadurch wird ein Ablösen des Schmelztropfens beim Durchschmelzen der Sicherung verhindert. Auch hier sind wieder mehrere Varianten möglich. In der in Fig. 3A gezeigten einfachsten Form verfügt die Schmelzsicherung 1 über eine leitfähige und schmelzbare Verbindung 2 zwischen zwei Anschlüssen 3. An einem dieser Anschlüsse 3 befindet sich der einzige Steg 4, der nach dem Einsetzen in eine Leiterplatte innerhalb des für diesen Anschluss bestimmten Durchbruchs der Leiterplatte ist. In der Variante von Fig. 3B besitzt die leitfähige und schmelzbare Verbindung 2 zwei in Reihe geschaltete Stege 4, jeweils einen an jedem der beiden Anschlüsse 3. Die Variante aus Fig. 3C verfügt über zwei in Reihe geschaltete leitfähige und schmelzbare Verbindungen 2, die jeweils über einen Steg 4 mit einem Anschluss 3 verbunden sind. Dabei stellt jeder dieser Anschlüsse 3 jeweils einen Endpunkt 6 der Reihenschaltung dar. Der Knotenpunkt 7 verfügt über einen weiteren Anschluss 3, in diesem Beispiel mit zwei Stiften 5 versehen. Wenn beide Endpunkte 6 auf der Leiterplatte verbunden werden, kann diese Form auch als eine leitfähige und schmelzbare Verbindung mit zwei parallel geschalteten Stegen 4 betrachtet werden. Die in Fig. 3D gezeigte Schmelzsicherung 1 verfügt über vier leitfähige und schmelzbare Verbindungen 2, die jeweils von einem Knotenpunkt 8 über einen Steg 4 zu einem Anschluss 3 führen. Werden jeweils die zwei benachbarten dieser Anschlüsse 3 auf der Leiterplatte verbunden, so ergibt sich eine Schmelzsicherung mit einer einzelnen leitfähigen und schmelzbaren Verbindung 2, bei der zwei Paare von Stegen 4 in Reihe geschaltet sind.

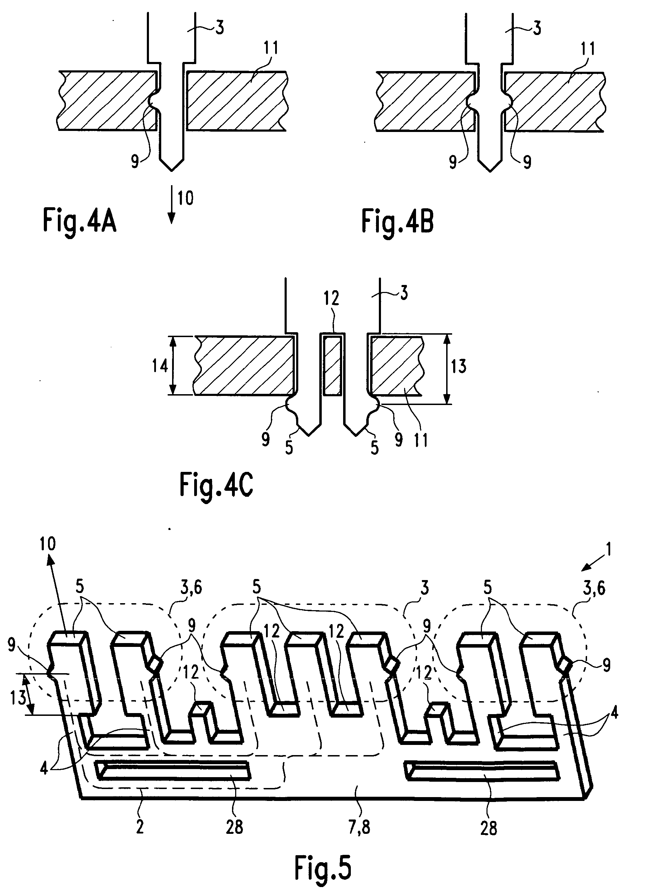

Eine weitere vorteilhafte Weiterbildung ist in Fig. 4 gezeigt. In Fig. 4A besitzt ein Anschluss 3 im Wesentlichen quer zur Einführungsrichtung 10 in eine Leiterplatte 11 einen Vorsprung 9. Während die Abmessungen von Anschluss 3 an seinem zum Einführen in den Durchbruch der Leiterplatte 11 bestimmten Teil kleiner sind als die entsprechenden Abmessungen des dazugehörigen Durchbruchs, ist die Breite in Höhe des Vorsprungs 9 gleich groß oder etwas größer als die entsprechende Dimension des Durchbruchs, so dass die Schmelzsicherung im eingesetzten Zustand durch eine Presspassung in ihrer Position in der Leiterplatte fixiert wird. Wie in Fig. 4B gezeigt, kann ein Anschluss 3 auch über mehrere dieser Vorsprünge verfügen, in diesem Beispiel liegen sich zwei Vorsprünge 9 im Wesentlichen senkrecht zur Einführungsrichtung 10 gegenüber.

Die in Fig. 4C gezeigte Schmelzsicherung besitzt zwischen den Stiften 5 des Anschlusses 3 eine definierte Auflagefläche 12, die die Schmelzsicherung in eingesetztem Zustand auf der Oberfläche der Leiterplatte abstützt. Dadurch dass der Abstand 13 der Vorsprünge 9 von der Auflagefläche 12 im Wesentlichen der Dicke 14 der Leiterplatte entspricht, für die die Schmelzsicherung bestimmt ist, wird ein Einrasten der Schmelzsicherung in der Leiterplatte im eingesetzten Zustand erzielt. Exakt betrachtet ist der Abstand 13 der Vorsprünge 9 von der Auflagefläche 12 mindestens gleich groß wie die Dicke 14, im Allgemeinen aber geringfügig größer.

In Fig. 5 ist beispielhaft eine mögliche tatsächliche Ausführungsform der vorliegenden Erfindung gezeigt. Sie verfügt über vier schmelzbare Stege 4 und sieben Stifte 5. Die mittleren drei Stifte bilden zusammen einen Anschluss 3, mit dessen Hilfe der Knotenpunkt 7 leitfähig mit Leiterbahnen einer Leiterplatte verbunden werden kann. In einer ersten möglichen Anwendung sind die zwei Stifte 5 der äußeren Stiftpaare jeweils mit der selben Leiterbahn verbunden, so dass sie jeweils zusammen einen Anschluss 3 bilden. Somit besitzt die Schmelzsicherung zwei elektrisch leitfähige und schmelzbare Verbindungen 2, von denen in Fig. 5 aus Gründen der Übersichtlichkeit nur eine markiert und beziffert ist. Die zweite befindet sich spiegelbildlich dazu auf der rechten Seite der Abbildung. Jede leitfähige und schmelzbare Verbindung 2 verfügt über zwei parallel geschaltete schmelzbare Stege 4. Somit verfügt die Schmelzsicherung über zwei in Reihe geschaltete elektrisch leitfähige und schmelzbare Verbindungen, wobei sich jeweils an den Endpunkten 6 und am Knotenpunkt 7 Anschlüsse 3 befinden, die wiederum jeweils aus mehreren Stiften 5 bestehen.

In einer zweiten Anwendung können die Stifte der äußeren Stiftpaare jeweils getrennte Stromkreise absichern. Dadurch erhält man vier leitfähige und schmelzbare Verbindungen, die an einem gemeinsamen Knoten 8 angeschlossen sind.

Zur Fixierung der Schmelzsicherung in einer Leiterplatte im eingesetzten Zustand, verfügt die Schmelzsicherung über sechs Vorsprünge 9 quer zur Einführungsrichtung 10 der Schmelzsicherung in die Leiterplatte. Der Querschnitt der Bohrungen oder Durchbrüche in der Leiterplatte wird so gewählt, dass die Stifte 5 ohne die Vorsprünge 9 darin Spiel haben, sich mit den Vorsprüngen 9 jedoch eine Presspassung ergibt. Auflageflächen 12 stützen die Schmelzsicherung im eingesetzten Zustand auf der Oberfläche der Leiterplatte ab. Der Abstand 13 in Einführungsrichtung 10 zwischen den Vorsprüngen 9, d.h. dem Punkt ihrer größten Ausdehnung quer zur Einführungsrichtung 10, und den Auflageflächen 12 ist entsprechend der Leiterplattendicke so gewählt, dass die Schmelzsicherung im eingesetzten Zustand in der Leiterplatte einrastet. Dadurch wird ein Herausfallen der Schmelzsicherung direkt nach dem Bestücken und in dem Fall, dass die Lötstellen zwischen der Schmelzsicherung und den entsprechenden Leiterbahnen geschmolzen sind, verhindert.

Zur Verbesserung der Auslöseeigenschaften verfügt die in Fig. 5 gezeigte Schmelzsicherung außerdem über zwei Schlitze 28. Die geschlitzte Form ermöglicht einen geringen elektrischen Widerstand zwischen den äußeren und mittleren Anschlüssen, ohne die Wärmeableitung von den Stegen 4 merklich zu erhöhen. Dadurch erwärmen sich die Stege in Folge einer Lasterhöhung schneller, was das Ansprechen der Schmelzsicherung beschleunigt.

Die vorliegende tatsächliche Ausführungsform der erfindungsgemäßen Schmelzsicherung wird durch Stanzen einstückig aus Zinkblech gefertigt.

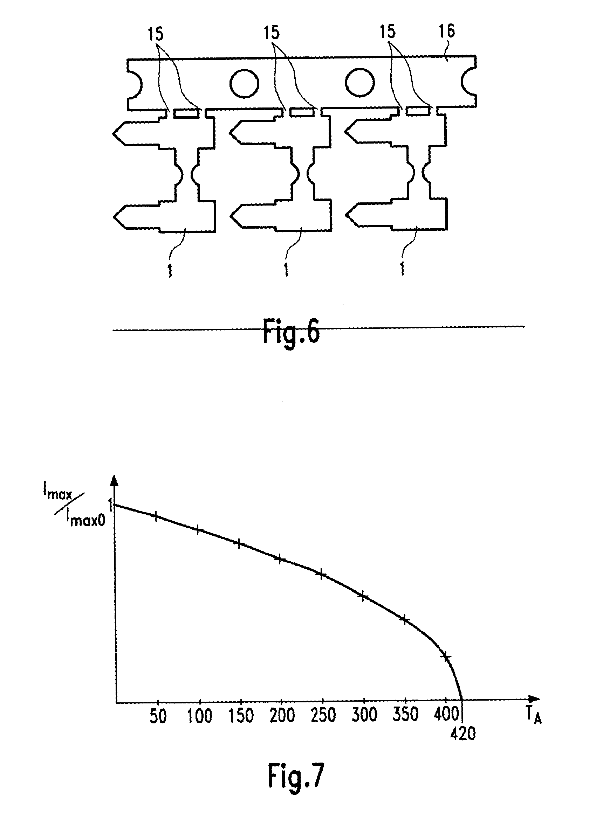

Zur vereinfachten Handhabung bei der Herstellung, dem Transport und der Bestückung der Schmelzsicherungen 1 können diese so gefertigt werden, dass sie durch brechbare, schneidbare oder stanzbare Verbindungen entweder an einem Gurt 16 oder untereinander angehängt sind (siehe Fig. 6). Dabei können alle Schmelzsicherungen 1 sowie gegebenenfalls der Gurt 16 aus einem Blechstück gefertigt werden. Vor der Montage auf der Leiterplatte können die Schmelzsicherungen durch einen geeigneten Arbeitsvorgang entweder vom Gurt 16 oder untereinander getrennt werden.

Der Strom $I_{max}$, der ein Durchschmelzen der Schmelzsicherung verursacht, hängt im Allgemeinen von der Umgebungstemperatur $T_A$, der Schmelztemperatur $T_S$ des Materials der Schmelzsicherung und dem Wärmewiderstand $R_\lambda$ zwischen dem Steg der Schmelzsicherung und der Umgebung ab. Dieser Zusammenhang soll im Folgenden näherungsweise hergeleitet werden. Ein Wärmefluss $\Phi$ erzeugt an einem Wärmewiderstand $R_\lambda$ eine Temperaturdifferenz $\Delta T$, die durch Gleichung 1 definiert ist.

$$\Phi = \frac{\Delta T}{R_\lambda} \qquad\qquad (1)$$

dabei gilt

$$\Delta T = T_S - T_A \qquad\qquad (2),$$

wobei $T_S$ die Temperatur am Steg der Schmelzsicherung und $T_A$ die Umgebungstemperatur darstellt. Die in Wärme umgesetzte elektrische Verlustleistung beträgt

$$P_{DISS} = I^2 \cdot R_{el} \qquad\qquad (3)$$

mit $R_{el}$ als elektrischem Widerstand des Stegs. Der elektrische Widerstand hängt gemäß

$$R_{el} = R_{el0} \, (1 + \alpha T_S) \qquad\qquad (4)$$

von der Temperatur des Stegs ab, wobei $R_{el0}$ der elektrische Widerstand bei 0°C und $\alpha$ eine Materialkonstante ist. Im Gleichgewichtsfall beträgt

$$\Phi = P_{DISS} \qquad\qquad (5).$$

Daraus ergibt sich folgender Zusammenhang zwischen dem fließenden Strom und der Temperatur am Steg:

$$I = \frac{(1 - T_A / T_S)}{(1 + \alpha T_S)} \cdot \sqrt{\frac{T_S}{R_\lambda \cdot R_{el0}}} \qquad\qquad (6)$$

Zur Ermittlung des Stroms $I_{max}$, bei dem der Steg die Schmelztemperatur $T_M$ erreicht, muss in Gleichung 6 $T_S = T_M$ eingesetzt werden und es ergibt sich

$$I_{max} = \frac{(1 - T_A / T_M)}{(1 + \alpha T_M)} \cdot \sqrt{\frac{T_M}{R_\lambda \cdot R_{el0}}} \qquad\qquad (7)$$

Daraus folgt eine Erniedrigung des maximalen Stroms, bei dem die Schmelzsicherung durchschmilzt, in Abhängigkeit von einer erhöhten Umgebungstemperatur. Dieser Zusammenhang ist in Fig. 7 beispielhaft für das Material Zink dargestellt, dessen Schmelztemperatur $T_M$ bei 419,5°C liegt. Aus Fig. 7 ergibt sich, dass eine starke Abhängigkeit des Maximalstroms von der Umgebungstemperatur durch die Wahl eines Materials mit niedrigem Schmelzpunkt erreicht wird. Um dennoch einen hohen Maximalstrom zu erreichen, muss gemäß Gleichung 7 für einen kleinen Wärmeableitwiderstand $R_\lambda$ gesorgt werden. Dieser kann beispielsweise dadurch erreicht werden, dass Anschlüsse der Schmelzsicherung über eine kurze und breite Leiterbahn auf der Leiterplatte mit einer Kontaktfläche zur Wärmeableitung verbunden werden, die ihrerseits durch eine geeignete Struktur, wie z.B. einem Kühlkörper, mit einem niedrigen Wärmeübergangswiderstand auf Umgebungstemperatur $T_A$ gehalten wird.

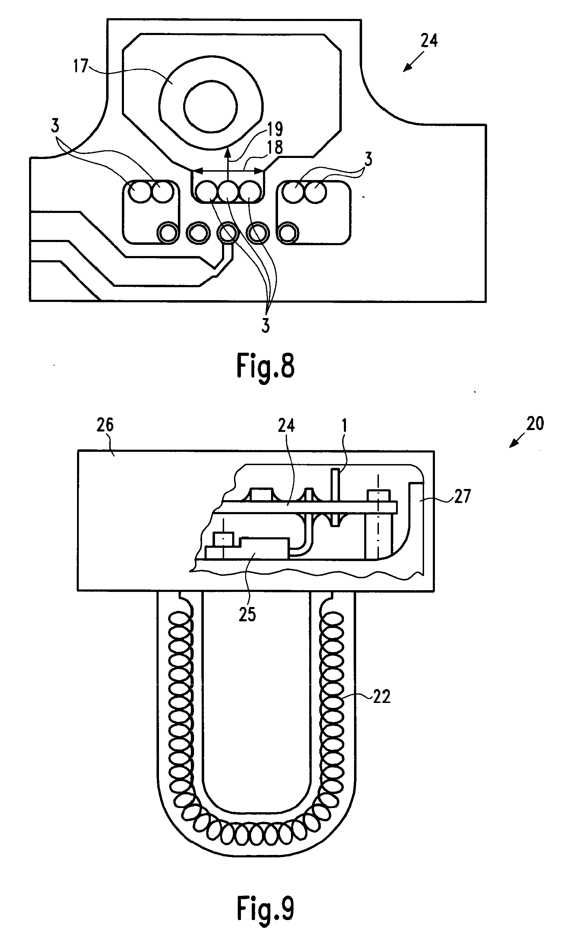

Die Leiterbahnstruktur in einem Ausschnitt einer geeigneten Leiterplatte 24 ist in Fig. 8 gezeigt. Man erkennt drei Anschlüsse 3, wobei die äußeren jeweils zwei Stifte umfassen und der mittlere Anschluss drei Stifte umfasst. Der mittlere Anschluss 3 ist mit einer Kontaktfläche 17 zur Wärmeableitung über eine Leiterbahn der Mindestbreite 18 verbunden, wobei 19 den kürzesten Weg auf der Leiterbahn von Anschluss 3 nach der Kontaktfläche 17 darstellt. Dadurch dass die Breite 18 der Leiterbahn größer gehalten ist als ihre Länge 19, kann der Wärmeableitungswiderstand $R_\lambda$ klein gehalten werden.

Eine Abhängigkeit des Maximalstroms $I_{max}$ von der Umgebungstemperatur $T_A$ wie oben beschrieben, wird z.B. dann gewünscht, wenn Bauelemente zum Einsatz kommen, deren Strombelastbarkeit von der Umgebungstemperatur abhängt. Dies wird im Allgemeinen bei Reglern und Schaltern mit Halbleiterbauelementen der Fall sein, da die oben hergeleiteten Gleichungen 1 bis 3 für diese auch gelten.

Ein Anwendungsbeispiel für die oben beschriebene Leiterplatte, die mit mindestens einer erfindungsgemäßen Schmelzsicherung bestückt ist, ist in einer elektrischen Heizvorrichtung gegeben. Eine solche Heizvorrichtung 20 ist schematisch in Fig. 9 gezeigt. Sie kann beispielsweise zur Beheizung einer Flüssigkeit oder eines vorbeiziehenden Luftstromes verwendet werden.

Ein Heizelement 22 wird durch einen Strom beheizt, der mit Hilfe der gedruckten Schaltung auf der Leiterplatte 24 gesteuert wird. Insbesondere ist im Heizkreis ein Halbleiterschalter 25 und eine erfindungsgemäße Schmelzsicherung 1 mit dem jeweiligen Heizelement in Reihe geschaltet. Das geschlossene Gehäuse 26 und der Kühlkörper 27 halten die Halterleiterschalter 25 und die Schmelzsicherungen 1 auf annähernd gleicher Umgebungstemperatur. Bei erhöhter Umgebungstemperatur $T_A$ unterbricht daher die Schmelzsicherung 1 den Heizkreis bei einem niedrigeren Strom $I_{max}$. Dadurch wird der Halbleiterschalter 25 optimal vor Überlast geschützt.

**Patentansprüche**

1. Schmelzsicherung (1) zum definierten Unterbrechen einer elektrischen Verbindung bei Überlast mit mindestens einem ersten und einem zweiten Anschluss (3), elektrisch verbindbar mit Leiterbahnen auf der Leiterplatte; und
mindestens einer leitfähigen und schmelzbaren Verbindung (2) zwischen dem ersten und dem zweiten Anschluss, wobei die Schmelzsicherung einstückig gefertigt ist.

2. Schmelzsicherung nach Anspruch 1, gefertigt aus einem Material, dessen Schmelzpunkt höher als 220°C und niedriger als 1085°C liegt.

3. Schmelzsicherung nach Anspruch 2, gefertigt aus Blech.

4. Schmelzsicherung nach Anspruch 3, wobei die Schmelzsicherung durch Stanzen, Laserschneiden, Wasserstrahlschneiden oder Ätzen herstellbar ist.

5. Schmelzsicherung nach Anspruch 3 oder 4, gefertigt aus Zink.

6. Schmelzsicherung nach Anspruch 1, gefertigt aus leitfähigem Kunststoff.

7. Schmelzsicherung nach einem der Ansprüche 1 bis 6, bei der zumindest einer der Anschlüsse (3) in Durchbrüche einer Leiterplatte (11) einsetzbar ist.

8. Schmelzsicherung nach Anspruch 7, bei der an zumindest einem der in Durchbrüche einer Leiterplatte einsetzbaren Anschlüsse mindestens ein Vorsprung (9) im wesentlichen quer zur Einführungsrichtung (10) des jeweiligen Anschlusses in einen Durchbruch der Leiterplatte (11) ausgebildet ist, der mit dem Durchbruch zum Fixieren der Schmelzsicherung zusammen wirkt.

9. Schmelzsicherung nach Anspruch 8, mit
einer Auflagefläche (12), um die Schmelzsicherung in einem eingesetzten Zustand der Anschlüsse in einer Leiterplatte (11) auf der Oberfläche der Leiterplatte abzustützen,
wobei zumindest einer der Vorsprünge in Einführungsrichtung des Anschlusses einen Abstand (13) von der Auflagefläche besitzt, welcher im Wesentlichen einer vorgegebenen Dicke (14) der Leiterplatte entspricht, um die Schmelzsicherung in einem eingesetzten Zustand auf der Leiterplatte einzurasten.

10. Schmelzsicherung nach einem der Ansprüche 7 bis 9, wobei zumindest einer der in Durchbrüche einer Leiterplatte einsetzbaren Anschlüsse (3) aus mehreren Stiften (5) besteht.

11. Schmelzsicherung nach einem der Ansprüche 7 bis 10, wobei zumindest eine der leitfähigen und schmelzbaren Verbindungen (2) einen leitfähigen und schmelzbaren Steg (4) an einer Stelle aufweist, die sich nach Montage der Schmelzsicherung auf einer Leiterplatte (11) innerhalb eines Durchbruches in der Leiterplatte befindet.

12. Schmelzsicherung nach einem der Ansprüche 1 bis 11, bei der mindestens ein Anschluss für eine flächige Verbindung mit Leiterbahnen auf der Leiterplatte ausgebildet ist.

13. Schmelzsicherung nach Anspruch 12, bei dem zumindest einer der für eine flächige Verbindung ausgebildeten Anschlüsse einen Durchbruch oder eine Einbuchtung für eine Schraubverbindung oder Nietverbindung aufweist.

14. Schmelzsicherung nach einem der Ansprüche 1 bis 13, wobei die leitfähige und schmelzbare Verbindung (2) mindestens zwei parallel geschaltete leitfähige und schmelzbare Stege (4) aufweist.

15. Schmelzsicherung nach Anspruch 14, bei der sich zumindest einer der parallel geschalteten leitfähigen und schmelzbaren Stege (4) in der Größe seiner minimalen Querschnittsfläche von anderen der Stege unterscheidet.

16. Schmelzsicherung nach einem der Ansprüche 1 bis 15, mit mindestens drei Anschlüssen (3) und mindestens zwei leitfähigen und schmelzbaren Verbindungen (2), wobei mindestens zwei der leitfähigen und schmelzbaren Verbindungen in Reihe geschaltet sind, und die Anschlüsse jeweils an Enden (6) der Reihenschaltung sowie an Knotenpunkten (7) zwischen den leitfähigen und schmelzbaren Verbindungen angeschlossen sind.

**17.** Schmelzsicherung nach einem der Ansprüche 1 bis 16, mit mindestens zwei Anschlüssen (3) und mindestens zwei leitfähigen und schmelzbaren Verbindungen (2), wobei jeder Anschluss über jeweils eine leitfähige und schmelzbare Verbindung mit einem gemeinsamen elektrischen Knotenpunkt (8) verbunden ist.

**18.** Schmelzsicherung nach einem der Ansprüche 1 bis 17, die in einem Anlieferungszustand durch mindestens eine brechbare, schneidbare oder stanzbare Verbindung an einen Gurt (16) angehängt ist, wobei die Schmelzsicherung und der Gurt aus einem Stück gefertigt sind.

**19.** Eine Leiterplatte (24), bestückt mit mindestens einer Schmelzsicherung (1) nach einem der Ansprüche 1 bis 18.

**20.** Leiterplatte nach Anspruch 19, bei der
die Anschlüsse (3) der Schmelzsicherung (1) mit Leiterbahnen elektrisch und wärmeleitfähig verbunden sind; und zumindest eine der Leiterbahnen eine Kontaktfläche (17) zur Wärmeableitung besitzt.

**21.** Leiterplatte nach Anspruch 20, bei der eine durchschnittliche Breite (18) von zumindest einer Leiterbahn im wesentlichen größer als eine Länge (19) der Leiterbahn zwischen der Kontaktfläche (17) zur Wärmeableitung und demjenigen mit der Leiterbahn verbundenen Anschluss (3) der Schmelzsicherung ist, welcher am nächsten zu der Kontaktfläche zur Wärmeableitung gelegen ist.

**22.** Heizvorrichtung (20) mit mindestens einer Leiterplatte (14) nach einem der Ansprüche 19 bis 21.

**23.** Heizvorrichtung (20) nach Anspruch 22, die weiterhin mindestens einen Halbleiterschalter (25) zum Schalten eines Heizstromes umfasst, wobei das Gehäuse des Halbleiterschalters mit der Schmelzsicherung (1) thermisch derart verbunden ist, dass für beide eine im Wesentlichen gleiche Umgebungstemperatur herrscht.

101

102

103

104

Fig.1

Fig.2A    Fig.2B    Fig.2C

Fig.2D    Fig.2E

Fig.2F    Fig.2G

Fig.2H  Fig.2I  Fig.2K

Fig.3A  Fig.3B

Fig.3C  Fig.3D

Fig.4A

Fig.4B

Fig.4C

Fig.5

Fig.6

Fig.7

Fig.8

Fig.9

**Europäisches Patentamt**

**EUROPÄISCHER RECHERCHENBERICHT**

Nummer der Anmeldung

EP 05 00 8912

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | DE 86 08 286 U1 (WILHELM PUDENZ GMBH, 2833 DUENSEN, DE) 22. Mai 1986 (1986-05-22) * das ganze Dokument * ----- | 1-7,10, 12,19,20 | H01H85/10 |
| X | WO 94/03913 A (SIEMENS AKTIENGESELLSCHAFT) 17. Februar 1994 (1994-02-17) * das ganze Dokument * ----- | 1-4,12, 13,18-20 | |
| X | US 4 349 804 A (GAIA ET AL) 14. September 1982 (1982-09-14) | 1-4 | |
| Y | * das ganze Dokument * ----- | 7-10 | |
| Y | US 4 071 290 A (DENIGRIS ET AL) 31. Januar 1978 (1978-01-31) * das ganze Dokument * ----- | 7-10 | |
| X | DE 103 02 793 A1 (LISA DRAEXLMAIER GMBH; AUDIO OHM DI TONANI CATERINA E C. S.N.C., MAIOC) 19. August 2004 (2004-08-19) * das ganze Dokument * ----- | 1-5 | |
| X | US 5 929 739 A (TOTSUKA ET AL) 27. Juli 1999 (1999-07-27) * das ganze Dokument * ----- | 1,13 | RECHERCHIERTE SACHGEBIETE (Int.Cl.7) H01H |
| X | US 4 224 592 A (URANI ET AL) 23. September 1980 (1980-09-23) * das ganze Dokument * ----- | 1,18 | |
| A | US 6 147 586 A (SAITOH ET AL) 14. November 2000 (2000-11-14) * das ganze Dokument * ----- | 14-17 | |
| A | EP 1 182 680 A (SUMITOMO WIRING SYSTEMS, LTD) 27. Februar 2002 (2002-02-27) * Abbildung 1a * ----- | 16 | |

Der vorliegende Recherchenbericht wurde für alle Patentansprüche erstellt

| Recherchenort | Abschlußdatum der Recherche | Prüfer |
|---|---|---|
| Den Haag | 5. Oktober 2005 | Ruppert, H |

EPO FORM 1503 03.82 (P04C03)

## ANHANG ZUM EUROPÄISCHEN RECHERCHENBERICHT
### ÜBER DIE EUROPÄISCHE PATENTANMELDUNG NR.

EP 05 00 8912

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

05-10-2005

| Im Recherchenbericht angeführtes Patentdokument | | Datum der Veröffentlichung | Mitglied(er) der Patentfamilie | | Datum der Veröffentlichung |
|---|---|---|---|---|---|
| DE 8608286 | U1 | 22-05-1986 | KEINE | | |
| WO 9403913 | A | 17-02-1994 | KEINE | | |
| US 4349804 | A | 14-09-1982 | CA | 1175871 A1 | 09-10-1984 |
| | | | DE | 3219905 A1 | 16-12-1982 |
| | | | ES | 273595 U | 16-04-1984 |
| | | | FR | 2507006 A1 | 03-12-1982 |
| | | | GB | 2103031 A | 09-02-1983 |
| | | | IT | 1152216 B | 31-12-1986 |
| | | | JP | 1616256 C | 30-08-1991 |
| | | | JP | 2030136 B | 04-07-1990 |
| | | | JP | 57210537 A | 24-12-1982 |
| | | | MX | 152316 A | 26-06-1985 |
| US 4071290 | A | 31-01-1978 | BE | 858950 A1 | 16-01-1978 |
| | | | CA | 1084564 A1 | 26-08-1980 |
| DE 10302793 | A1 | 19-08-2004 | KEINE | | |
| US 5929739 | A | 27-07-1999 | KEINE | | |
| US 4224592 | A | 23-09-1980 | AU | 525247 B2 | 28-10-1982 |
| | | | BE | 875005 A1 | 24-09-1979 |
| | | | BR | 7901913 A | 27-11-1979 |
| | | | CA | 1116215 A1 | 12-01-1982 |
| | | | CH | 632869 A5 | 29-10-1982 |
| | | | DE | 2912018 A1 | 11-10-1979 |
| | | | ES | 479254 A1 | 01-07-1980 |
| | | | ES | 8101323 A1 | 01-03-1981 |
| | | | FR | 2422250 A1 | 02-11-1979 |
| | | | GB | 2024541 A | 09-01-1980 |
| | | | IT | 1192701 B | 04-05-1988 |
| | | | JP | 1438862 C | 19-05-1988 |
| | | | JP | 54135339 A | 20-10-1979 |
| | | | JP | 61038568 B | 29-08-1986 |
| | | | MX | 146188 A | 21-05-1982 |
| | | | NL | 7902110 A | 05-10-1979 |
| | | | PH | 17963 A | 22-02-1985 |
| | | | SE | 442930 B | 03-02-1986 |
| | | | SE | 7902803 A | 04-10-1979 |
| | | | ZA | 7901587 A | 30-04-1980 |
| US 6147586 | A | 14-11-2000 | KEINE | | |
| EP 1182680 | A | 27-02-2002 | US | 2002024414 A1 | 28-02-2002 |

Für nähere Einzelheiten zu diesem Anhang : siehe Amtsblatt des Europäischen Patentamts, Nr.12/82